# EUROPEAN PATENT APPLICATION

(11) **EP 1 033 393 A2**
(43) Date of publication of application: **06.09.2000**
(21) Application number: 00104169.8
(22) Date of filing: 29.02.2000
(51) Int. Cl.: C09J 7/02, C08J 9/32

(54) **Heat-peelable pressure-sensitive adhesive sheet**

(30) Priority: 01.03.1999 JP 5299699
(71) Applicant: NITTO DENKO CORPORATION, Osaka (JP)
(72) Inventor: Kiuchi, Kazuyuki, c/o Nitto Denko Corporation, Ibaraki-shi, Osaka (JP); Oshima, Toshiyuki, c/o Nitto Denko Corporation, Ibaraki-shi, Osaka (JP); Murata, Akihisa, c/o Nitto Denko Corporation, Ibaraki-shi, Osaka (JP); Arimitsu, Yukio, c/o Nitto Denko Corporation, Ibaraki-shi, Osaka (JP)
(74) Representative: Grünecker, Kinkeldey, Stockmair & Schwanhäusser Anwaltssozietät

(57) **Abstract**

A heat-peelable adhesive sheet which shows small increase in the degree of contamination caused by a heat treatment for lowering an adhesive force is disclosed. The heat-peelable pressure sensitive adhesive sheet comprises a heat-expandable layer containing heat-expandable microspheres and expanding upon heating, and. a non-heat expandable pressure-sensitive adhesive layer formed on at least one side thereof. The heat-peelable pressure-sensitive adhesive sheet can achieve the desired adhesive properties such as an excellent adhesive force before heating and also show a quick lowering of the adhesive force upon heating. Further, it shows small increase in the degree of contamination due to the treatment for lowering the adhesive force. Due to those characteristics, the heat-peelable pressure-sensitive adhesive sheet is practically applicable to, for example, the production of electronic parts made of thinner semiconductor wafers.

## Description

### FIELD OF THE INVENTION

The present invention relates to a heat-peelable pressure-sensitive adhesive sheet which can decrease its adhesive force upon heating and, therefore, can easily be peeled from an adherend without contamination, so that the sheet is suitably applicable to, for example, electronic parts.

### BACKGROUND OF THE INVENTION

Heat-peelable pressure-sensitive adhesive sheets comprising a substrate and a pressure-sensitive adhesive layer containing a foaming agent, formed thereon have conventionally been known (see, for example, JP-B-50-13878, JP-B-51-24534, JP-A-56-61468, JP-A-56-61469 and JP-A-60-252681; the term "JP-B" as used herein means an "examined Japanese patent publication", and the term "JP-A" as used herein means an "unexamined published Japanese patent application"). The pressure-sensitive adhesive force of those heat-peelable pressure-sensitive adhesive sheets can be lowered by a heat treatment for foaming or expanding the pressure-sensitive adhesive layer, so that they can easily be peeled from an adherend. Those heat-peelable pressure-sensitive adhesive sheets have been used in, for example, tentative fixation in the production step of ceramic condensers.

However, the conventional heat-peelable pressure-sensitive adhesive sheets suffer from a problem that, when it is used in dicing or back side-polishing semiconductor wafers, the wafers have a number of extremely fine (i.e., visually invisible) contaminants remaining thereon after heating and then peeling the tapes off, which sometimes makes these wafers unusable in practice. This problem of contamination is caused by a remarkable increase in the contaminants due to the heat treatment, compared with the amount of the contaminants before heating. When contaminants on a 4-inch silicon wafer are counted with a laser surface examination apparatus, it is generally observed that a wafer has less than 1,000 contaminants after peeling a sheet without heating, but the number of contaminants exceeds 10,000 after heating, thus showing an increase in the degree of contamination by 10 times or more.

### SUMMARY OF THE INVENTION

The present invention aims at obtaining a heat-peelable pressure-sensitive adhesive sheet which shows little increase in the degree of contamination caused by a heat treatment carried out to lower the adhesive force, thereby developing a pressure-sensitive adhesive sheet causing only a slight degree of contamination of an adherend, and therefore is applicable in practice to, for example, the production of electronic parts made of semiconductor wafers.

Accordingly, one object of the present invention is to provide a heat-peelable pressure-sensitive adhesive sheet comprising a non-heat expandable pressure-sensitive adhesive layer and a heat-expandable layer containing heat-expandable microspheres and expanding upon heating, formed on at least one side thereof.

The present invention makes it possible to obtain a heat-peelable pressure-sensitive adhesive sheet wherein its adhesive force can quickly be lowered by heating while achieving the desired pressure-sensitive adhesive properties such as an excellent adhesive force before heating due to the heat-expandable layer using the heat-expandable microspheres and the pressure-sensitive adhesive layer formed thereon and increase in the degree of contamination of an adherend due to the treatment for lowering its adhesive force is small. It is believed that this effect of preventing an increase in the degree of contamination is due to the covering effect of the pressure-sensitive adhesive layer on the heat-expandable layer, but considering the fact that lowering the adhesive force is also achieved, the detailed mechanism of developing such effects is unclear.

However, it is practically significant to simultaneously achieve lowering the adhesive force and preventing an increase in the degree of contamination by the structure such that the pressure-sensitive adhesive layer is formed on the heat-expandable layer. By those effects, a heat-peelable sheet which causes a low degree of contamination of an adherend after heat-peeling and is practically usable in, for example, the production of electronic parts made of semiconductor wafers can be obtained by using a contamination-preventive pressure-sensitive adhesive layer in which contamination after peeling, such as adhesive remaining, is less. As a result, the thickness of wafers, which has conventionally been restricted by the problem of breakage in peeling caused by the residual adhesive force, like contamination-preventive type ultraviolet-curing pressure-sensitive adhesive layers, can be further reduced by using such a sheet having a lowered adhesive force.

### BRIEF DESCRIPTION OF THE DRAWINGS

Fig. 1 is a sectional view of one embodiment of the present invention.
Fig. 2 is a sectional view of another embodiment of the present invention.

In the drawings, each numerical symbol has the following meaning:
- 1:: Substrate
- 2, 21:: Heat-expandable layer
- 3, 31:: Pressure-sensitive adhesive layer
- 4:: Separator
- 5 :: Rubber-like organic elastic layer.

### DETAILED DESCRIPTION OF THE INVENTION

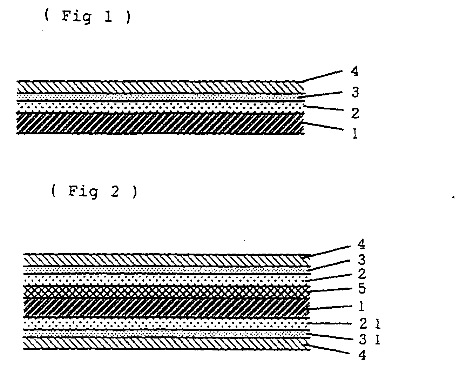

The heat-peelable pressure-sensitive adhesive sheet according to the present invention comprises a heat-expandable layer containing heat-expandable microspheres and expanding upon heating, and a non-heat expandable adhesive layer formed on at least one side thereof. Figs. 1 and 2 show examples thereof. In these figures, the numerical symbols 2 and 21 each represent a heat-expandable layer; 3 and 31 each represent a pressure-sensitive adhesive layer; and 1, 4 and 5 represent a substrate, a separator and a rubber-like organic elastic layer, respectively, that may be provided if desired and necessary.

The heat-expandable layer contains heat-expandable microspheres and expands upon heating. By the uneven deformation caused by the expansion, the pressure-sensitive adhesive layer provided on the surface of the heat-expandable layer also undergoes uneven deformation and thus the adhesive force thereof to an adherend is lowered. Therefore, the heat-peelable pressure-sensitive adhesive sheet adhered to the adherend can easily be peeled from the adherend by heating the heat-expandable layer whenever needed.

The heat-expandable layer can be formed by, for example, mixing the heat-expandable microspheres with a binder. Appropriate materials such as polymers or waxes allowing the foaming and/or expansion of the heat-expandable microspheres upon heating can be used as the binder. In particular, it is preferable to use materials not restricting the foaming and/or expansion of the heat-expandable microspheres as less as possible. Considering heat-expandability of the heat-expandable microspheres and controllability of pressure-sensitive adhesive properties (for example, the adhesive force to an adherend through the pressure-sensitive adhesive layer), pressure-sensitive adhesives are particularly preferably used as the binder.

The pressure-sensitive adhesive is not particularly limited. Examples of the pressure-sensitive adhesive that can be used include pressure-sensitive adhesives using polymers such as rubber polymers, acrylic polymers, vinylalkyl ether polymers, silicone polymers, polyesters, polyamides, urethane polymers, fluoropolymers or styrene/butadiene copolymers, pressure-sensitive adhesives containing holt melt resins having a melting point of, for example200°C or lower to improve creep properties, ultraviolet-curing pressure-sensitive adhesives, and pressure-sensitive adhesives optionally containing various additives such as crosslinking agents, tackifiers, plasticizers, softeners, fillers, pigments, coloring matters, antioxidants and surfactants (see, for example, JP-A-56-61468, JP-A-61-174857, JP-A-63-17981 and JP-A-56-13040). Those can be used alone or as mixtures of two or more thereof.

From the point of the balance between the controllability of the adhesive force of the heat-peelable pressure-sensitive adhesive sheet to an adherend through the pressure-sensitive adhesive layer before heating and lowering of the adhesive force upon heating, pressure-sensitive adhesives using as a base polymer a polymer having a dynamic modulus of elasticity of 50,000 to 10,000,000 dyn/cm² in a temperature region of from ordinary temperature to 150°C are preferable, the pressure-sensitive adhesives used in the present invention are not limited to those.

Examples of the tackifiers generally used include rubber tackifiers using, as a base polymer, rubber-type polymers (for example, natural rubber, polyisoprene rubber; styrene/butadiene rubber, styrene/isoprene/styrene block copolymer, styrene/butadiene/styrene block copolymer, reclaimed rubber, butyl rubber, polyisoprene rubber or NBR), and acrylic tackifiers using, as a base polymer, acrylic polymers comprising alkyl acrylates or alkyl methacrylates.

Examples of the acrylic polymers include acrylates or methacrylates having straight-chain or branched alkyl groups having 1 to 20, in particular 4 to 18, carbon atoms, such as methyl group, ethyl group, propyl group, butyl group, amyl group, hexyl group, heptyl group, 2-ethylhexyl group, isooctyl group, isononyl group, isodecyl group, dodecyl group, lauryl group, tridecyl group, tetradecyl group, pentadecyl group, hexadecyl group, heptadecyl group, octadecyl group, nonadecyl group or eicosyl group. Those may be used alone or as mixtures of two or more thereof.

The acrylic polymers may be those obtained by copolymerizing one or more appropriate monomers so as to improve, for example, cohesive force, heat stability or crosslinking properties. The copolymerizable monomers are not particularly limited so long as it can be copolymerized with the alkyl (meth)acrylates.

Examples of the copolymerizable monomers include carboxyl group-containing monomers such as acrylic acid, methacrylic acid, carboxyethyl acrylate, carboxypentyl acrylate, itaconic acid, maleic acid, fumaric acid or crotonic acid, add anhydride monomers such as maleic anhydride or itaconic anhydride, and hydroxyl group-containing monomers such as hydroxyethyl (meth)acrylate, hydroxypropyl (meth) acrylate, hydroxybutyl (meth)acrylate, hydroxyhexyl (meth) acrylate, hydroxyoctyl (meth)acrylate, hydroxydecyl (meth)acrylate, hydroxylauryl (meth)acrylate or (4-hydroxymethylcyclohexyl) methyl(meth)acrylate.

Further examples of the copolymerizable monomers include sulfonate group-containing monomers such as styrenesulfonic acid, allylsulfonic acid, 2-(meth) acrylamido-2-methylpropanesulfonic acid, (meth)acrylamidopropanesulfonic acid, sulfopropyl (meth)acrylate or (meth)acryloyloxynaphthalenesulfonic acid, phosphate group-containing monomers such as 2-hydroxyethylacryloyl phosphate, (N-substituted) amide monomers such as (meth)acrylamide, N,N-dimethyl (meth)acrylamide, N-butyl (meth)acrylamide, N-methylol (meth)acrylamide or N-methylolpropane (meth)acrylamide, alkylamino (meth)acrylate monomers such as aminoethyl (meth)acrylate, N,N-dimethylaminoethyl (meth)acrylate or t-butylaminoethyl (meth) acrylate, alkoxyalkyl (meth)acrylate monomers such as methoxyethyl (meth)acrylate or ethoxyethyl (meth)acrylate, maleimide monomers such as N-cyclohexyl maleimide, N-isopropyl maleimide, N-lauryl maleimide or N-phenyl maleimide, itaconimide monomers such as N-methyl itaconimide, N-ethyl itaconimide, N-butyl itaconimide, N-octyl itaconimide, N-2-ethylhexyl itaconimide, N-cyclohexyl itaconimide or N-lauroyl itaconimide, and succinimide monomers such as N-(meth)acryloyloxymethylene succinimide, N-(meth)acryloyl-6-oxyhexamethylene succinimide or N-(meth)acryloyloxy-8-oxyoctamethylene succinimide.

Further examples of the copolymerizable monomers include vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrrole, vinylimidazole, vinyloxazole, vinylmorpholine, N-vinyl carbonamide, styrene, α-methylstyrene or N-vinylcaprolactam, cyanoacrylate monomers such as acrylonitrile or methacrylonitrile, epoxy group-containing acrylic monomers such as glycidyl (meth)acrylate, glycol acrylate monomers such as polyethylene glycol (meth)acrylate, polypropylene glycol (meth)acrylate, methoxyethylene glycol (meth)acrylate or methoxypropylene glycol (meth)acrylate, acrylate monomers such as tetrahydrofurfuryl (meth) acrylate, fluorine (meth)acrylate, silicone (meth)acrylate or 2-methoxyethyl acrylate, polyfunctional monomers such as hexanediol di(meth) acrylate, polyethylene glycol di(meth)acrylate, (poly)propylene glycol di(meth)acrylate, neopentylglycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylate, polyester acrylate, urethane acrylate, divinylbenzene, butyl diacrylate or hexyl diacrylate, isoprene, butadiene, isobutylene and vinyl ether.

On the other hand, examples of the heat-expandable microspheres used in the beat-expandable layer include microcapsules obtained by encapsulating an appropriate substance which can be easily gasified and shows heat-expandability (for example, isobutane, propane or heptane) in a shell made of a shell-forming material such as a hot-melt material or a material which can be broken upon heat expansion (for example, vinylidene chloride/acrylonitrile copolymer, polyvinyl alcohol, polyvinyl butyral, polymethyl methacrylate, polyacrylonitrile, polyvinylidene chloride or polysulfone) by an appropriate method such as coacervation or interfacial polymerization.

Use of the heat-expandable microspheres can stably prevent an increase in the degree of contamination of an adherend due to heating. In a foaming agent that is not microencapsulated, for example, effect of preventing an increase in the degree of contamination becomes poor because of probably the cohesive failure of the pressure-sensitive adhesive layer forming the surface. From the standpoint of, for example, the handling properties to lower the adhesive force by heating (in particular, the achievement of the stable lowering of the adhesive force), it is preferable to use heat-expandable microspheres showing a volume expansion ratio up to rupture of 5 or more, preferably 7 or more and more preferably 10 or more.

The average particle size of the heat-expandable microspheres to be used can appropriately be determined. In general, heat-expandable microspheres having an average particle size of 100 µm or less, preferably 80 µm or less and more preferably from 1 to 50 µm, are used, but the present invention is not limited thereto. There are commercially available heat-expandable microspheres, for example, MICROSPHERE™ (manufactured by Matsumoto Yushi Seiyaku).

The amount of the heat-expandable microspheres used may appropriately be determined by, for example, the expansion ratio of the heat-expandable layer and the degree of lowering of the adhesive force. In general, in the case of the above-described binders and pressure-sensitive adhesives, the heat-expandable microspheres are used in an amount of from 1 to 150 parts by weight, preferably form 10 to 130 parts by weight and more preferably form 25 to 100 parts by weight, per 100 parts by weight of the base polymer.

The heat-expandable layer can be formed by, for example, mixing the heat-expandable microspheres with other components such as a binder together with, if desired and necessary, a solvent, and spreading the resulting mixture in an appropriate manner such as coating to form a sheet-like layer. The thickness of the layer can appropriately be determined depending on, for example, the degree of lowering of the adhesive force.

If the thickness of the layer is too small, the uneven deformation of the surface caused by the heat-expandable microspheres brings about the uneven deformation of the pressure-sensitive adhesive layer formed thereon, thereby failing to achieve a sufficient adhesive force. Further, the pressure-sensitive adhesive layer formed on the heat-expandable layer undergoes cohesive failure upon heating and, as a result, the degree of contamination of the adherend increases. Furthermore, if the layer thickness is too large, the adhesive force lowers insufficiently because of the insufficient deformation upon heating. To prevent the above disadvantages, the thickness of the heat-expandable layer is 300 µm or less, preferably from 2 to 200 µm and more preferably from 5 to 150 µm.

In forming the heat-expandable layer, if required and necessary the heat-expandable layer 2 may be supported by a substrate 1, as shown in the drawings. This embodiment has some advantages such that the heat-expandable layer and also the pressure-sensitive adhesive layer are supported and reinforced by the substrate, so that the handling properties of the heat-peelable pressure-sensitive adhesive sheet are improved and the heat-peelable pressure-sensitive adhesive sheet can efficiently be adhered to an adherend and, then peeled therefrom after heating.

Examples of the substrate that can be used are appropriate thin materials capable of supporting the heat-expandable layer, for example, porous materials such as paper, fabrics, nonwoven fabrics or nets, plastic films, rubber sheets, foamed sheets, metal foils and laminates thereof. Of those, thin materials having excellent heat resistance that do not melt at the heat treatment of the heat-expandable layer are preferable from the standpoints of, for example, handling properties.

The substrate may be a material that has been treated by, for example, stretching so as to control the deformation properties such as elongation. Where the pressure-sensitive adhesive layer is treated by, for example, ultraviolet light, a substrate that permeates its treating light is used. The thickness of the substrate can appropriately be determined depending on, for example, its strength and flexibility and the purpose of the use. The thickness is generally 500 µm or less, preferably from 3 to 300 µm and more preferably form 5 to 250 µm, but it is not limited thereto.

The sheet of the above-described substrate-supporting embodiment can be formed by an appropriate method, for example, a method of conducting the above-described spreading procedure on the substrate to directly form the heat-expandable layer on the substrate, or a method of forming the heat-expandable layer on a separator according to the above procedure and then transferring this heat-expandable layer on the substrate.

Examples of the separator include substrate in which the above-described substrate is surface-treated with an appropriate release agent such as silicone types, long-chain alkyl types, fluorine types or molybdenum sulfide, low adhesive substrates comprising a fluoropolymer such as polytetrafluoroethylene, polychlorotrifluoroethylene, polyvinyl fluoride, polyvinylidene fluoride, tetrafluoroethylene/hexafluoropropylene copolymer or chlorotrifluoroethylene/vinylidene fluoride copolymer, and low adhesive substrates comprising a non-polar polymer such as polyethylene or polypropylene. The separator can also be used as the substrate supporting the heat-expandable layer.

As shown in the drawings, the heat-expandable layer can be provided on one or both sides of the substrate, and the substrate can also be embedded in the heat-expandable layer. A substrate having excellent adhesion to the heat-expandable layer can be obtained by, for example, using a film comprising a highly polar polymer such as polyester, or by subjecting the substrate to an appropriate treatment such as surface oxidation by a chemical or physical procedure such as a chromic acid-treatment, exposure to ozone, exposure to flame, exposure to high-voltage electric shock or ionizing radiation.

To improve the adhesiveness of the substrate to the heat-expandable layer, it is effective to form an undercoating layer on the substrate. In the embodiment that the heat-expandable layer is supported by the substrate, it is also possible to form one or more intermediate layers between the substrate and the heat-expandable layer. The intermediate layer may be one having an appropriate purpose, for example, a coat layer made of a release agent for imparting peelability as described above or an undercoating layer for improving the adhesiveness as described above.

In addition to the peelable coat layer and the undercoating layer as described above, examples of the intermediate layer include layers aiming at imparting good deformation properties, layers aiming at enlarging the adhesion area to an adherend, layers aiming at improving the adhesive force, layers aiming at establishing good follow-up property to a surface shape of an adherent, layers aiming at facilitating the lowering of the adhesive force upon heating, and layers aiming at improving the peelability from an adherend after heating.

To impart deforming properties and improve the peelability after heating, it is effective to provide a rubber-like organic elastic layer 5 as an intermediate layer as shown in Fig. 2. This rubber-like organic elastic layer has a function to follow-up the pressure-sensitive adhesive layer on the surface to the surface shape of the adherend to thereby provide a large adhesion area when the heat-peelable pressure-sensitive adhesive sheet is adhered to the adherend; a function of increasing controllability of expansion of the heat-expandable layer upon heating; and a function to predominantly expand the heat-expandable layer in the thickness direction rather than in the plane direction to thereby form an expanded layer having excellent uniformity in thickness.

Taking above functions into consideration, the rubber-like organic elastic layer is preferably formed using a natural rubber or a synthetic rubber, having rubber elasticity which has a D-scale Shore hardness (determined in accordance with ASTM D-2240 D-scale Shore) of 50 or less, preferably 45 or less and more preferable 40 or less; or a synthetic resin having a rubber elasticity. From the standpoints of the functions as described above, the rubber-like organic elastic layer has a thickness of generally 500 µm or less, preferably from 3 to 300 µm and more preferably from 5 to 150 µm, but the thickness is not limited thereto.

Examples of the synthetic rubber or synthetic resin include nitrile-based, diene-based or acrylic synthetic rubbers, polyolefin-based or polyester-based thermoplastic elastomers, and synthetic resins having rubber elasticity ethylene/vinyl acetate copolymer, polyurethane, polybutadiene or flexible polyvinyl chloride. Even in substantially a hard polymer such as polyvinyl chloride, if it is blended with additives such as a plasticizer or a softener to impart rubber elasticity, such can be used in the present invention.

The rubber-like organic elastic layer may be made of a pressure-sensitive adhesive substance comprising above-described forming materials as the main component. Alternatively, it may be made of, for example, a foamed film mainly comprising such components. The rubber-like organic elastic layer can be formed by an appropriate method, for example, a method of applying a solution of the forming material to a substrate or a method of adhering a film made of the forming material to the substrate. From the standpoints of the above-described functions, it is preferable to overlay the rubber-like organic elastic layer on the side of the heat-expandable layer opposite the side on which the pressure-sensitive adhesive layer is formed, thereby forming a laminate form. Where the pressure-sensitive adhesive layer is treated with, for example, ultraviolet light, the intermediate layer used is a layer that permeates the treating light.

The pressure-sensitive adhesive layer is formed on the heat-expandable layer in order to protect an adherend from an increase in the contaminants (in particular, fine contaminants) in adhering to the adherend and lowering the adhesive force by heating. The pressure-sensitive adhesive layer can be formed using an appropriate pressure-sensitive adhesive depending on the aimed pressure-sensitive adhesive properties (for example, the adhesive force to the adherend), and the kind of the pressure-sensitive adhesive used is not particularly limited. As a result, the above-described pressure-sensitive adhesives as listed above with respect to the heat-expandable layer and also conventional pressure-sensitive adhesives can be used. Pressure-sensitive adhesives that do not restrict the deformation of the heat-expandable layer upon heating are preferable. However, the pressure-sensitive adhesive is generally a curing pressure-sensitive adhesive, and is preferably, for example, a ultraviolet-curing pressure-sensitive adhesive, an acrylic curing pressure-sensitive adhesive and a radiation-curing pressure-sensitive adhesive.

Examples of the pressure-sensitive adhesive preferably used include those containing appropriate crosslinking agents, for example, polyfunctional crosslinking agents such as tolylene diisocyanate, trimethylolpropane tolylene diisocyanate or diphenylmethane trisiocyanate, epoxy crosslinking agents such as polyethylene glycol diglycidyl ether, diglycidyl ether or trimethylolpropane triglycidyl ether, melamine crosslinking agents such as alkyl ether melamine compounds, metal salt crosslinking agents, metal chelate crosslinking agent, amino crosslinking agents, peroxide crosslinking agents and coupling crosslinking agents such as silane coupling agents.

Where it is particularly required to protect an adherend from contamination, for example, in case of producing an electronic part made of a semiconductor wafer by back side-polishing the semiconductor wafer having a circuit pattern formed thereon and dicing the same to obtain a semiconductor chip, it is preferable to use an appropriate contamination-preventive adhesive represented by ultraviolet-curing pressure-sensitive adhesives or non-ultraviolet-curing pressure-sensitive adhesives such as acrylic pressure-sensitive adhesives or radiation-curing pressure-sensitive adhesives.

The ultraviolet-curing pressure-sensitive adhesives are such that photopolymerization initiators are blended with pressure-sensitive adhesives comprising polymers obtained by copolymerizing monomers having crosslinkable functional groups (for example, polyfunctional monomers) or pressure-sensitive adhesives containing crosslinkable low-molecular weight compounds (for example, polyfunctional monomers) so that crosslinking and curing can be conducted upon ultraviolet irradiation. Thus, the contaminants to an adherend can be reduced by the crosslinking and curing and, at the same time, the adhesive force can be lowered, if necessary.

Examples of the ultraviolet-curing pressure-sensitive adhesives used may be appropriate ultraviolet-curing types containing, as the photopolymerization initiator, 4-(2-hydxoxyethoxy)phenyl(2-hydroxy-2-propyl)ketone, acetophenone initiators such as α-hydroxy-α,α'-dimethylacetophenone, methoxyacetophenone, 2,2-dimethoxy-2-phenylacetophenone, 2,2- diethoxyacetophenone, 1-hydroxycyclohexyl phenyl ketone or 2-methyl-1-[4-(methylthio)-phenyl] -2-morpholinopropane-1, benzoin ether initiators such as benzoin ethyl ether, benzoin propyl ether or anisoin methyl ether, α-ketol compounds such as 2-methyl-2-hydroxypropiophenone, ketal compounds such as benzyl dimethyl ketal, aromatic sulfonyl chloride compounds such as 2-naphthalenesulfonyl chloride, optically active oxime compounds such as 1-phenone-1,1-propanedione-2-(o-ethoxycarbonyl)oxime, benzophenone compounds such as benzophenone, benzoylbenzoic acid or 3,3-dimethyl-4-methoxybenzophenone, thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone or 2,4-diisopropylthioxanthone, camphor quinone, halogenated ketones, acyl phosphinoxide and acyl phosphonate.

The pressure-sensitive adhesive used in forming the pressure-sensitive adhesive layer may contain appropriate additives such as a plasticizer, a filler, a surfactant, an antioxidant or a tackifier as described above. However, pressure-sensitive adhesives having an additive-free composition can also be used in the use that the transfer of these additives to an adherend arises a problem, for example, the case that a low degree of contamination is desired as described above.

The pressure-sensitive adhesive layer can be formed by an appropriate method, for example, a method of applying a liquid pressure-sensitive adhesive on the heat-expandable layer or a method of forming the pressure-sensitive adhesive layer on a separator and then transferring it to the heat-expandable layer. The thickness of the pressure-sensitive adhesive layer can appropriately be determined depending on, for example, the purpose of the utilization of the pressure-sensitive adhesive sheet and the desired extent of lowering the adhesive force upon heating.

In general, if the pressure-sensitive adhesive layer is too thin, cohesive failure tends to occur due to insufficient adhesive force or at the time of the uneven deformation of the heat-expandable layer, and if the pressure-sensitive adhesive layer is too thick, it becomes difficult to follow-up the uneven deformation of the heat-expandable layer upon heating. Therefore, the thickness of the pressure-sensitive adhesive layer is 20 µm or less, preferably from 0.1 to 10 µm and more preferably from 1 to 5 µm, from the standpoints of preventing the cohesive failure at the time heat deformation, preventing an increase in the degree of contamination of the adherend, ensuring the follow-up property of uneven deformation to the heat-expandable layer and lowering or losing the adhesive force to the adherend.

As discussed above, the heat-peelable pressure-sensitive adhesive sheet according to the invention can be formed into an appropriate form. In such a case, the pressure-sensitive adhesive layer may be formed on one or both sides of the heat-expandable layer. Alternatively, the heat-expandable layer and the pressure-sensitive adhesive layer may be formed on one side of the substrate and a usual pressure-sensitive adhesive layer may be formed on the other side thereof. In the embodiment that the heat-expandable layer is supported by a substrate, a separation type can be formed such that the substrate is easily peeled off from the rubber-like organic elastic layer or the heat-expandable layer or a fixation type can be formed such that the substrate is strongly adhered to the rubber-like organic elastic layer or the heat-expandable layer.

The heat-peelable pressure-sensitive adhesive sheet of the separation type as described above can be formed using a separator or a low adhesive substrate as described before. Further, the heat-peelable pressure-sensitive adhesive sheet of the fixation type can be formed using a high adhesive substrate or a surface-oxidized substrate as described above. It is preferable that the pressure-sensitive adhesive layer is protected from lowering the adhesive force due to contamination until practical use by tentatively adhering the separator 4 or the like, as shown in Fig. 1.

The heat-peelable pressure-sensitive adhesive sheet according to the invention can be molded into appropriate forms such as sheets, tapes or labels and used in various uses, for example, adhering to adherents, similar to the conventional pressure-sensitive adhesive sheets. The sheet can easily be separated from an adherend by lowering its adhesive force by heating whenever needed. By taking advantage of this characteristic, the heat-peelable pressure-sensitive adhesive sheet is preferably used in the case that it is needed or desired to adhere the heat-peelable adhesive sheet to an adherend for definite period of time and then separate therefrom. The adherend is not particularly limited and may be made of arbitrary materials such as metals, ceramics, plastics, wood or paper. The adhesion face may be in an arbitrary shape such as a plane face, a curved face or a fibrous face.

Specifically, the heat-peelable pressure-sensitive adhesive sheet of the present invention is used to working and/or protecting an adherend by adhering the adherend to the heat-peelable pressure-sensitive adhesive sheet comprising a heat-expandable layer containing heat-expandable microspheres and expanding upon heating and. a non-heat expandable pressure-sensitive adhesive layer formed on at least one face thereof, heating the sheet to expand and/or foam the heat-expandable layer, reducing and/or losing a pressure-sensitive force of the non-heat-expandable pressure-sensitive adhesive layer, and peeling and recovering the adherend.

Examples of the uses include formation of adhered composite articles for the purpose of recycling, of, for example, articles comprising polymers and articles comprising meals, fibers or papers; carrier tapes, tentatively fixing members or fixing members for, for example, transporting or tentatively fixing parts in the assembling step of various electric or electronic devices or display devices; and surface-protective materials or masking materials for protecting metal plates, plastic plates or glass plates from contamination and breakage.

In particular, the present invention can appropriately set the pressure-sensitive adhesive properties such as the adhesive force through the pressure-sensitive adhesive layer depending on the purpose of the use. Further, from that increase in contaminants, in particular, micro-contaminants, due to a lowering treatment of the adhesive force by heating is small, the heat-peelable pressure-sensitive adhesive sheet of the present invention is preferably used in uses that it can adhere to an adherend with a high adhesive force in working and contamination of the adherend after removing the adhered state as in, for example, back side-polishing treatment or dicing treatment of semiconductor wafers, is desired to be small.

The heat treatment for lowering the adhesive force of the heat-peelable pressure-sensitive adhesive sheet can be performed through an appropriate heating means, for example, a hot plate, a hot air dryer or a near infrared lamp. The heat treatment conditions can appropriately be determined depending on various conditions such as reduction of the adhesion area due to the surface conditions of the adherend or the type of the heat-expandable microspheres, the heat resistance and heat capacity of the substrate and the adherend, and the heating means.

In general, the heat treatment is carried out at 100 to 250°C for 5 to 90 seconds (in case of using, for example, a hot plate) or 1 to 15 minutes (in case of using, for example, a hot air dryer), but the present invention is not limited thereto. By the heat treatment under these conditions, the heat-expandable microspheres are usually expanded and/or foamed and thus the heat-expandable layer undergoes uneven deformation. As a result, the pressure-sensitive adhesive layer also undergoes uneven deformation and the adhesive force is lowered or lost thereby.

The present invention is described in more detail by reference to the following Examples, but it should be understood that the invention is not construed as being limited thereto. Unless otherwise indicated, all parts, percents ratios or the like are by weight.

### EXAMPLE 1

35 Parts of heat-expandable microspheres (MICROSPHERE F-50D) were blended with an acrylic pressure-sensitive adhesive A prepared by blending 2 parts of an isocyanate crosslinking agent with a solution containing 100 parts of an acrylic copolymer composed of 100 parts of butyl acrylate, 5 parts of acrylonitrile and 3 parts of hydroxyethyl acrylate. The resultant mixture was applied on one side of a PET film having a thickness of 50 µm and dried to form a heat-expandable layer having a thickness of 40 µm. A contamination-preventive pressure-sensitive adhesive layer having a thickness of 3 µm was then formed on the heat-expandable layer to obtain a heat-peelable pressure-sensitive adhesive sheet.

The contamination-preventive pressure-sensitive adhesive layer was formed by applying an acrylic pressure-sensitive adhesive which was prepared by blending 3 parts of an epoxy crosslinking agent with a toluene solution containing 100 parts of an acrylic copolymer composed of 50 parts of butyl acrylate, 50 parts of ethyl acrylate, 10 parts of acrylonitrile and 5 parts of acrylic acid, on a separator followed by drying, and transferring the dried film.

### EXAMPLE 2

30 Parts of heat-expandable microspheres (MICROSPHERE F-30) were blended with an acrylic adhesive prepared by blending 3 parts of an isocyanate crosslinking agent with a toluene solution containing 100 parts of an acrylic copolymer B composed of 70 parts of ethyl acrylate, 30 parts of butyl acrylate and 5 parts of hydroxyethyl acrylate. The resulting mixture was applied on one side of a transparent PET film having a thickness of 25 µm and dried to form a heat-expandable layer having a thickness of 30 µm. A contamination-preventive and ultraviolet-curing adhesive layer having a thickness of 2 µm was formed on the heat-expandable layer to obtain a heat-peelable pressure-sensitive adhesive sheet.

The contamination-preventive and ultraviolet-curing pressure-sensitive adhesive layer was formed by applying an acrylic adhesive which was prepared by blending 100 parts of urethane acrylate and 3 parts of a photopolymerization initiator with 100 parts of the acrylic copolymer B, on a separator followed by drying, and transferring the dried film.

### COMPARTIVE EXAMPLE 1

A heat-peelable pressure-sensitive adhesive sheet was prepared in the same manner as in Example 1 except that a pressure-sensitive adhesive layer was not formed on the heat-expandable layer.

### COMPARTIVE EXAMPLE 2

A heat-peelable pressure-sensitive adhesive sheet was prepared in the same manner as in Example 2 except that a pressure-sensitive adhesive layer was not formed on the heat-expandable layer.

### COMPARATIVE EXAMPLE 3

A heat-peelable pressure-sensitive adhesive sheet was prepared in the same manner as in Example 1 except that a pressure-sensitive adhesive was formed by using the acrylic pressure-sensitive adhesive A alone without any heat-expandable microspheres blended therewith and a pressure-sensitive adhesive layer was not formed thereon.

### EVALUATION TEST

### Adhesive force:

A sample (width: 20 mm) of each of the heat-peelable pressure-sensitive adhesive sheet sheets obtained in the Examples and the Comparative Examples was adhered to a polyester film having a thickness of 25 µm (LUMILAR S-10; manufactured by Toray) and the 180° peel adhesive force (peeling speed: 300 mm/min, 23°C) was examined. The samples of Examples 1 and Comparative Examples 1, 2 and 3 were measured before heating and after heating in a hot air dryer at 130°C for 3 minutes, the sample of Example 2 was measured before ultraviolet irradiation and also before heating, after ultraviolet irradiation with an air-cooled high-pressure mercury lamp (46 mJ/min) for 10 seconds (hereinafter the same) and also before heating, before ultraviolet irradiation and also after heating in a hot air dryer at 100°C for 3 minutes (hereinafter the same), and after ultraviolet irradiation and also after heating.

### Particle count:

Each of the heat-peelable pressure-sensitive adhesive sheets obtained in the Examples and the Comparative Examples was adhered to a mirror-finished silicone wafer (4 inch) and allowed to stand for 1 hour. The sheet was peeled off in the same manner as in the test for measuring the adhesive force. Particles present on the wafer were counted with a laser surface examination apparatus.

The results obtained in Example 1 and Comparative Examples 1, 2 and 3 are shown in Table 1 below, and the results obtained in Example 2 are shown in Table 2 below.

**TABLE 1**

| | Adhesive force (gf/20mm) | | Particle count | |
|---|---|---|---|---|
| | Before heating | After heating | Before heating | After heating |
| Ex. 1 | 300 | 2 | 650 | 760 |
| C.Ex.1 | 350 | 0 | 800 | ≥ 10000 |
| C.Ex.2 | 280 | 0 | 720 | ≥ 10000 |
| C.Ex.3 | 310 | 420 | 800 | 830 |

**TABLE 2**

| | Before UV-irradiation/before heating | After UV-irradiation/before heating | Before UV-irradiation/after heating | After UV-irradiation/after heating |
|---|---|---|---|---|
| Adhesive force (gf/20mm) | 150 | 30 | 90 | 0 |
| Particle count | 300 | 20 | 4700 | 47 |

## Claims

1. A heat-peelable pressure-sensitive adhesive sheet comprising a heat-expandable layer containing heat-expandable microspheres and expanding upon heating and. a non-heat expandable pressure-sensitive adhesive layer formed on at least one face thereof.

2. The heat-peelable pressure-sensitive adhesive sheet as claimed in claim 1, wherein said heat-expandable layer shows an adhesiveness and is supported by a substrate and said pressure-sensitive adhesive layer is a curing pressure-sensitive adhesive.

3. The heat-peelable pressure-sensitive adhesive sheet as claimed in claim 2, wherein said curing pressure-sensitive adhesive is one member selected from the group consisting of a ultraviolet-curing pressure-sensitive adhesive, an acrylic curing pressure-sensitive adhesive and a radiation-curing pressure-sensitive adhesive.

4. The heat-peelable pressure-sensitive adhesive sheet as claimed in claim 1 or 2, wherein a rubber-like organic elastic layer is laminated with said heat-expandable layer.

5. A method of working or protecting an adherent, which comprises adhering the adherend to a heat-peelable pressure-sensitive adhesive sheet comprising a heat-expandable layer containing heat-expandable microspheres and expanding upon heating and. a non-heat expandable pressure-sensitive adhesive layer formed on at least one face thereof, heating the sheet to expand and/or foam the heat-expandable layer, reducing and/or losing a pressure-sensitive force of the non-heat-expandable pressure-sensitive adhesive layer and peeling and recovering the adherend.

6. Use of a heat-peelable pressure-sensitive adhesive sheet for protecting an adherend by adhering the adherend to a heat-peelable pressure-sensitive adhesive sheet comprising a heat-expandable layer containing heat-expandable microspheres and expanding upon heating and. a non-heat expandable pressure-sensitive adhesive layer formed on at least one face thereof, heating the sheet to expand and/or foam the heat-expandable layer, reducing and/or losing a pressure-sensitive force of the non-heat-expandable pressure-sensitive adhesive layer, and peeling and recovering the adherend.
